(19)

Europäisches
Patentamt
European
Patent Office
Office européen
des brevets

(11)  **EP 1 796 182 A1**

(12)  **EUROPEAN PATENT APPLICATION**

(43) Date of publication:
**13.06.2007  Bulletin 2007/24**

(51) Int Cl.:
*H01L 35/32* (2006.01)          *H01L 35/34* (2006.01)

(21) Application number: **05292627.6**

(22) Date of filing: **09.12.2005**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(71) Applicants:
• **Corning SAS
77920 Samois sur Seine (FR)**
• **Ecole Nationale Supérieure d'Ingénieurs de Caen
14050 Caen Cedex 4 (FR)**

(72) Inventors:
• **Marques, Paulo Jorge
77300 Fontainebleau (FR)**
• **Goupil, Christophe
14000 Caen (FR)**
• **Dannoux, Thierry Luc Alain
77210 Avon (FR)**

(74) Representative: **Boon, Graham Anthony
Elkington and Fife LLP,
Prospect House,
8 Pembroke Road
Sevenoaks,
Kent TN13 1XR (GB)**

(54)  **Thermoelectric device**

(57)   A thermoelectric device is provided which comprises a plurality of elements of a thermoelectric material, which are preferably either all of n-type material or all p-type. In this preferred device, each element has a first end region for exposure to a first temperature, and a second end region for exposure to a second temperature, with the temperature gradient being in the same direction in each of the elements, so each element develops a voltage between its end regions in the same direction. The first end regions of the elements are mounted on a substrate, but the second end regions of the elements are at least substantially free to move with respect to one another. The elements are connected electrically in series, so that the series connection produces a net voltage, the electrical connections being designed to produce only a small amount of heat conduction.

Fig. 3

EP 1 796 182 A1

**Description**

This invention relates to a thermoelectric device for generating electrical power when the device is exposed to a temperature gradient. It is particularly concerned with the generation of electrical power from the waste heat produced by power plants in which such heat arises as a by-product of the desired process. One particular example is the generation of electrical power from the waste heat produced by automotive engines, and this will be referred to in more detail below. However, it is to be understood that the device of the present invention can also be used in many other field of application. For example, it can be used to generate electric power from waste heat produced by other engines, for example the combustion engines used in other forms of transport, such as aircraft and boats. It can also be used to generate electrical power from stationary combustion units, for example from central heating systems, and other heating systems, in homes or business premises. Indeed, it can be used to generate electrical power from any system where there is either waste heat or, where the generation of heat is the primary purpose of the system, there is heat which can be spared for the purpose of power generation.

In the case of a typical automobile engine, approximately 75% of the energy from the fuel is wasted in thermal losses, and only approximately 25% is used for its intended purposes. Of that 25%, about 18% is currently used to propel the vehicle, and the remaining 7% is used as electrical energy in air conditioning systems, audio systems, electronic engine control, in-car navigation systems, vehicle lights, and so forth. This electrical energy is generated very inefficiently by the vehicle. Furthermore, the trend is for an ever increasing use of electrical and electronic devices in vehicles, with a corresponding increasing demand for electrical power in vehicles. It would therefore be highly desirable to provide a means by which at least part of the energy currently wasted in thermal losses is converted into electricity. It is one of the aims of the present invention to provide just such a means.

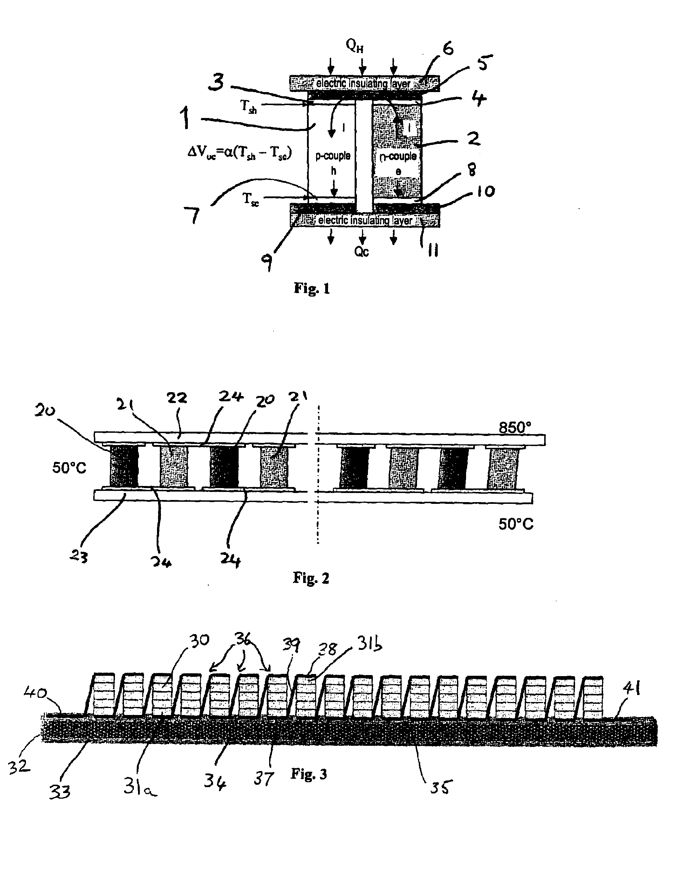

The basic principle on which a conventional thermoelectric device operates is illustrated in Figure 1 of the accompanying drawings. The device comprises two thermoelectric elements 1 and 2, element 1 being of a first type (here shown as p-type), and element 2 being of the opposite type (here shown as n-type). The elements 1, 2 are provided with respective electrically conducting layers 3, 4 which connect the first ends to an electrically conductive connecting member 5. A layer 6 formed from an electrical insulator is superposed on the connecting member 5. At their opposite ends the elements 1 and 2 are connected, via respect electrically conducting members 7 and 8 with a first electrical terminal 9 and a second electrical terminal 10. A layer 11 of electrically insulating material is superposed on the terminals 7 and 8.

In use, the insulating layer 6 is exposed to a source of heat, denoted as $Q_H$, and the insulating layer 11 is in thermal contact with a heat sink which serves to extract heat, denoted by $Q_C$ from the system. The result is the generation of an electric current I which is indicated in Figure 1, and which arises from electrons flowing to terminal 10 and positively charged holes flowing to terminal 9.

A thermoelectric device of the type shown in Figure 1 is satisfactory from a mechanical point of view, provided the temperature difference between its opposite ends is not too great. Typically, it is intended to function under circumstances where the temperature difference is of the order of from 100°C to 200°C. The problem which arises in conventional thermoelectric devices when the temperature difference is significantly greater than this can be understood by reference to Figure 2. This shows, diagrammatically, a conventional thermoelectric device in which a plurality of thermoelectric elements, half of which, denoted by numeral 20, are p-type, and half of which, denoted by numeral 21, are n-type are mounted between two substrates 22 and 23, and an electrical series connection is formed by electrodes 24 which alternately connect adjacent second ends and adjacent first ends of neighbouring thermoelectric elements. This connects the elements electrically in series. For simplicity, Figure 2 shows just two p-type devices and just two n-type devices, but it will be understood that, in practice, a significantly larger number of devices would normally be connected together.

The left hand portion of Figure 2 shows the device when both upper and lower substrates 22, 23 are at the same temperature, illustrated, by way of example, as being 50°C. The right hand side of Figure 2 shows the same device, but in this case when the lower substrate 23, which is connected to a heat sink, remains at 50°C, and the upper substrate 22 is exposed to a high temperature, shown as being 850°C. As can be seen, the upper substrate 22 has expanded by reason of this rise in temperature, compared to the lower substrate 23, creating a high degree of thermal stress within the device. By way of example, a piece of alumina which is 50 mm in length at 50°C increases in length by about 150 $\mu$m when heated to 850°C. The problem is exacerbated by the fact that, in a typical use, the hot side of the device is not exposed to a constantly high temperature, but is cycled repeatedly between a high temperature and a low temperature. This gives rise to a high risk of failure of the device. This problem is recognised in US2005/0016183 (Tateyama et al. ), which provides a number of different structures which are said to allow for the thermal stresses described above. However, the structures which Tateyama proposes are complex, and would therefore be expensive to manufacture, nor is it clear that any of them would, in practice, satisfactorily solve the problem.

The problem is, however, one which it would be highly desirable to solve in an economical manner, since thermoelectric devices are inefficient when the thermal gradient across them is low, but much more efficient when the temperature gradient is higher. The reason for this is as follows.

The figure of merit ($K^{-1}$) of a thermoelectric material is usually defined as:

$$Z=S^2\sigma/\kappa = S^2/\rho\kappa \qquad (1)$$

Where

S  is the Seebeck coefficient or thermopower (usually in V/K)
$\sigma$  is the electrical conductivity (in $S.cm^{-1}$)
$\rho$  is the electrical resistivity (in $\Omega.cm$)
$\kappa$  is the total thermal conductivity (in $W.cm^{-1}.K^{-1}$)

Since Z varies with temperature, thermoelectric materials are best rated by a dimensionless figure of merit, ZT, where T is temperature in K. The best thermoelectric materials have low thermal conductivity (behave as phonon glasses), high electrical conductivity (electronic crystals), and high thermopower. These properties are difficult to optimize simultaneously in a specific material since the three parameters in Z are not independent: in general, as S increases, so does $\rho$.

The ideal maximum output power P of a module is given by the expression:

$$P=(S.\Delta T)^2/(4\rho L) \qquad (2),$$

where $\Delta T = T_{hot} - T_{cold}$ is the difference of temperature between the hot and cold sources, and L is the length of the thermoelectric element.

As can be seen from equation (2), the output power of a thermoelectric device increases with the square of the temperature difference applied across it. Thus, a device where the heat sink is maintained at 50°C will, all other things being equal, generate 16 times as much power if its hot end is at 850°C (a temperature difference of 800°C), compared to a device where the hot end is maintained at 250°C, (a temperature difference of 200°C).

By way of further reference to the prior art, attention is directed to US2004/0107988 (Harman et al), which shows a thermoelectric device of rather different configuration to the conventional configuration show in Figure 1 herein. The device of the Harman application comprises only a single element of what would normally be regarded as a thermoelectric material, the place of the second element being taken by a metal wire. The Harman device is described there only in the context of its use to provide a temperature gradient when an electrical current flows through it (i.e. the reverse of the situation which is of interest in the context of the present application, where the application of a temperature gradient is used to generate an electrical current), and there is no suggestion in the Harman application that a plurality of the devices described therein could be combined with one another, nor how that might be done. It has been suggested in the prior art that one might theoretically connect a plurality of thermoelectric devices of the same type in series with one another, but the theoretical possibility has been dismissed on account of the amount of thermal shorting which it was thought would occur.

According to the invention there is provided a thermoelectric device comprising a plurality of elements of a thermoelectric material of the same type as one another, each having a first end region for exposure to a first temperature, and a second end region for exposure to a second temperature, with the temperature gradient being in the same direction in each of the elements, whereby each element is adapted to develop a voltage between its end regions in the same direction; a substrate on which the first end regions of the elements are mounted; and electrical connection means for connecting the elements electrically in series, so that the series connection produces a net voltage, the second end regions of the elements being able to move with respect to one another. Preferably, the second end regions are free to move, or at least substantially free to move, with respect to one another.

The ends of the elements which are mounted on the substrate are preferably the ends which are to be exposed to a higher temperature than that to which the other ends are exposed, although they may be the ends which are to be exposed to a lower temperature.

The first end regions of the elements preferably terminate in respective first end faces, and the second end regions preferably terminate in respective second end faces. The electrical connection means may then comprise, for each adjacent pair of elements, a connector member having a first end portion which extends at least partly across the first end face of one of the pair of elements, a second end portion which extends at least partly across the second end face of the other of the pair of elements, and an intermediate portion extending from the first end portion to the second end portion. The end faces which are to be exposed to the higher temperature may be coated with a material which is heat-resistant and electrically insulating, so that they can be contacted by metal plates to transfer heat thereto by conduction.

The intermediate portions mentioned above may, for example, be in the form of wires, or they may be in the form of sheets.

In a preferred construction each thermoelectric element comprises a base which provides one of the end regions, and a plurality of legs extending from the base and providing, at their ends remote from the base, the other of the end regions.

Although the device may be used in a flat configuration, it may be made sufficiently flexible to be wrapped around a surface which supplies heat to it, or acts as a heat sink taking heat from it, so as to be in thermal contact with that surface.

The means for connecting the thermoelectric elements in series may be formed of different types of material, or they may be formed of materials of opposite type. Provided any thermoelectric voltage generated by the connecting means is very small compared to that generated by the thermoelectric elements, either configuration can be used.

Preferably, the thermoelectric elements are disposed in an array with adjacent elements having sides which face one another across a gap, and wherein the connection means are located outside said gaps.

In another aspect of the invention there is provided a method of making a thermoelectric device comprising a plurality of elements of a thermoelectric material of the same type as one another, each having a first end region for exposure to a first temperature, and a second end region for exposure to a second temperature, with the temperature gradient being in the same direction in each of the elements, whereby each element is adapted to develop a voltage between its end regions in the same direction; a substrate on which the first end regions of the elements are mounted; and electrical connection means for connecting the elements electrically in series, so that the series connection produces a net voltage, the second end regions of the elements being able to move with respect to one another, the method comprising:

(a) forming the said plurality of elements by moulding;
(b) forming an electrode frame containing the electrical connection means;
(c) wrapping the electrode frame around the plurality of elements so as to establish the necessary electrical connections; and, optionally,
(d) breaking away any parts of the electrode frame not required to establish the necessary electrical connections.

The moulding step may comprise forcing material to form the thermoelectric elements into a planar mould, and expelling the moulded material therefrom. Alternatively, it may comprise bringing into forcible contact with one another material to form the thermoelectric elements and a rotating cylindrical mould having mould cavities formed on a cylindrical peripheral surface thereof, and thereafter allowing the moulded elements to leave mould cavities.

In yet another aspect, the invention provides a thermoelectric device comprising a plurality of elements of a thermoelectric material, each having a first end region for exposure to a first temperature, and a second end region for exposure to a second temperature, with the temperature gradient being in the same direction in each of the elements, a substrate on which the first end regions of the elements are mounted, and electrical connection means for connecting the elements electrically in series, so that the series connection produces a net voltage, the second end regions of the elements being able to move with respect to one another.

As used herein, reference to elements being of the same type as one another means that they are all p-type, or all n-type. They are not necessarily all identical, though they may be, and often would be.

As used herein, reference to a temperature gradient, in elements each of which has a first end and a second end, being in the same direction, means that all the elements have their first end at a higher temperature than their second end, or vice versa. The temperature at each of the first ends may be the same, or substantially the same, for all the elements, and the temperature at each of the second ends may be the same, or substantially the same, for all the elements, though this need not be the case.

The accompanying drawings illustrate a number of embodiments of thermoelectric device according to the invention, and illustrate methods which may be used to produce devices according to the invention. In the accompanying drawings:

Figure 1, described above, shows a conventional thermoelectric device;
Figure 2, described above, shows the effect of thermal expansion on a conventional thermoelectric device;
Figure 3 is a side view of an embodiment of the present invention;
Figure 4 is a perspective view of the embodiment of Figure 3, but with a reduced number of thermoelectric elements for ease of illustration;
Figure 5 is a view similar to Figure 3, but slightly modified;
Figures 6 and 6a are, respectively, a partly cut away side view and a cross-sectional view, of an embodiment according to the present invention in a cylindrical configuration;
Figures 7a to 7c show successive stages in moulding thermoelectric element which are subdivided into a number of segments;
Figure 8 is a perspective view of an intermediate product which represents the penultimate stage in the manufacture of a further embodiment of the invention;
Figure 9 is a perspective view of the product of Figure 8, from a different direction, after removal of some, but not all, of the wire portions which have to be removed to complete the making of the device;
Figures 10a to 10d show successive stages in forming thermoelectric elements for use in the present invention by moulding;
Figure 11 shows an alternative moulding process;
Figures 12, 13 and 16 are perspective views of successive stages in making another embodiment of the invention;

Figures 14 and 15 show, respectively, an electrode frame for use in providing the electrical connections used in the embodiment of Figures 12, 13 and 16, and the components of the frame which remain in the final thermoelectric device; and

Figure 17 is a graph showing how the voltage generated by an example of the invention varies with the temperature gradient.

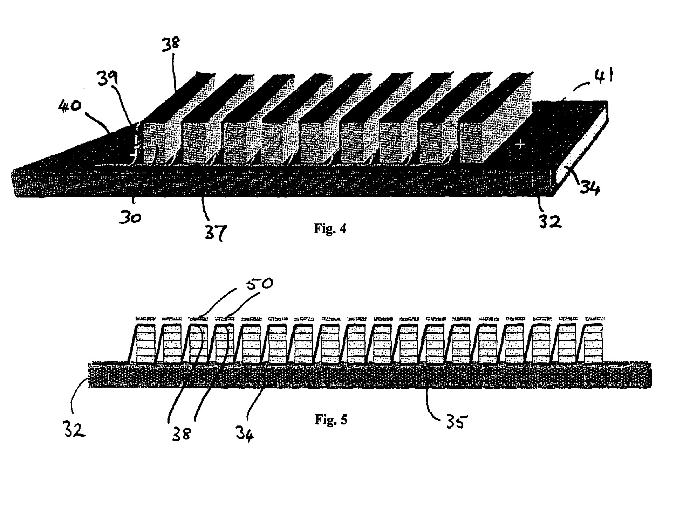

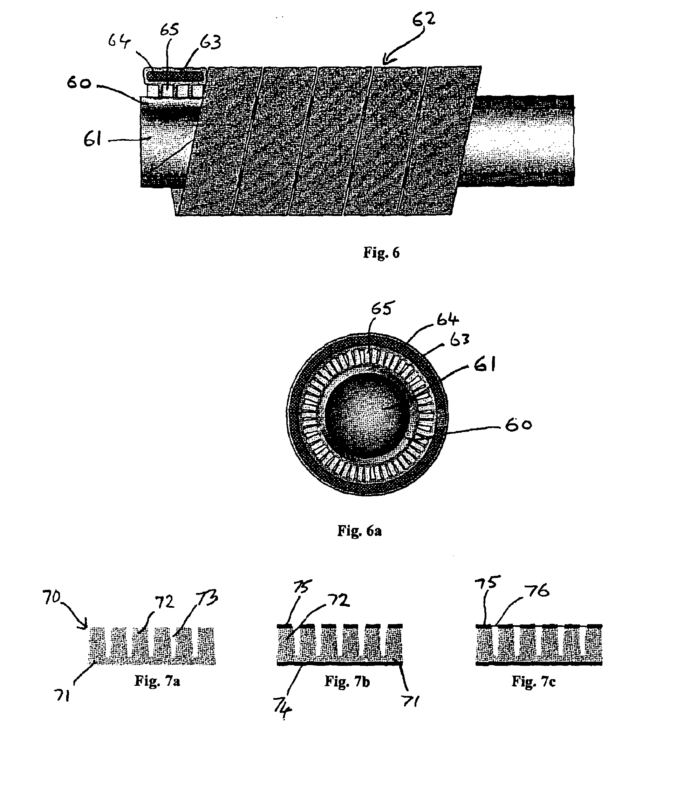

Figures 3 and 4 show diagrammatically a first embodiment of the invention. This comprises a plurality of thermoelectric elements 30 arranged side by side, all of the elements being of the same type, i.e. all being n-type or all being p-type. Each of the first ends 31a of the elements 30 is in thermal contact with a heat sink 32, shown here as a flattened duct 33 through which a coolant 34, preferably a liquid, such as water or other aqueous liquid, can flow. When the hot end of the device is at a very high temperature, as is envisaged in the preferred use of the present invention, the liquid in the duct 33 need not be what would normally be regarded as cold. For example, when used in an automotive road vehicle, such as a car, the liquid may be at 50°C or even more. Indeed, for most applications on land there is no source of colder liquid which can be employed as the heat sink, unless the device is used in an extremely cold climate. Because the hot end of the device is at a very high temperature, even with the cold end at 50°C or more there will still be a high temperature difference to generate a high thermoelectric voltage. Thermal contact between the duct 32 and the first ends 31 of the elements 30 is via an electrically insulating, but thermally conducting, layer 35, unless the duct 32 is itself made of such a material. (For ease of illustration the layer 35 has been omitted from Figure 5, but is shown in Figure 4). One material which may be used to provide the layer 35 is a glass enamel available as ESL 4986 from Agmet Ltd, of Reading, Berkshire, RG2 OQZ, England.

The elements 30 are connected electrically in series with one another. The series connection is provided by a plurality of electrical connectors 36. For each adjacent pair of elements 30 a respective connector 36 is provided having a first end portion 37 which extends at least partly across the end face of the first end 31a of one of the pair of elements, and a second end portion 38 which extends at least partly across the end face of the second end 31b of the other of the pair of elements. An intermediate connector portion 39 connects the first end portion 37 to the second end portion 38. At one end of the array of elements 30 the connector which runs from the second end face of the adjacent element provides a terminal 40 of a first polarity, and at the other end of the array a second terminal 41, of opposite polarity, runs from the first end face of the adjacent element.

The end portions 37 and 38 need to be in good electrical contact with the element end faces 31a and 31 b respectively. One way of achieving this is to use a conductive paste, for example a silver-based paste, which is applied between the respective end portions and end faces. One such paste is that which is available as ESI 9912-A from Agmet Ltd. When the assembly of connectors and thermoelectric elements is heated to about 850°C, the paste is baked to form a solid, thermally and electrically-conductive connection. Alternatively, where a suitable metal is used for the connectors, it is possibly to weld the connector end portions 37 and 38 directly to the end faces of the thermoelectric elements. Suitability for this purpose depends on the metal undergoing sufficient diffusion, at a temperature which is not unacceptably high, to form the desired electrical connection. Silver is an example of a metal which can be used, as sufficient diffusion occurs at around 940°C.

The connectors 36 which provide the electrical connections between adjacent elements are shown as being in the form of S-shaped plates. These need to provide not only a good electrical connection, but also to minimise conduction of heat through them from the hot side of the device to the cold side. For this purpose, the electrical connectors should be made of a material with very high electrical conductivity, for example silver or silver-plated copper. (Although copper alone could in theory be used, it is in practice not entirely satisfactory, as it tends to oxidise easily). Other materials which can be used include gold and platinum, though as these are relatively expensive they are best confined to structures in which the connections between adjacent elements are provided by wires rather than by plates, of which further details are given below in connection with other embodiments.

In order to reduce the rate at which heat is conducted through the electrical connectors, they should be made of as low cross section as possible, consistent with the need to provide sufficient electrical conductivity and mechanical strength. To this end, the material used should be thin, typically around 120 $\mu$m in thickness, and heat loss can be further reduced by having the intermediate portions 39 of the S-shaped connectors of lesser width than the end portions 37 and 38.

Although not normally thought of as thermoelectric materials, when a length of a metal is exposed to a thermal gradient between its ends, a voltage is produced. Some metals act as p-type elements, and some act as n-type elements. For example, gold is a p-type metal. However, the voltages concerned are very small compared to those produced by materials which are normally understood as being thermoelectric materials. For example, gold has a Seebeck coefficient at 300°K of +2.9$\mu$V/°K, compared to values of around 100 to 300 mV/°K for a typical thermoelectric material. In the context of the present invention, the term "thermoelectric element" is used in its conventional sense to refer to an element in which a thermal gradient produces a substantial voltage. It will be understood that in the construction shown in Figures 3 and 4, and, indeed, in the other embodiments described below, the output of the device will be dependent, to a very small extent, not only on the voltages generated by the thermoelectric elements, but also on the voltages generated in the connectors which run between them. If the thermoelectric elements and the connectors are materials of opposite type the voltages which they produce will be additive. If they are of the same type, the voltages of the connectors will subtract from the voltages produced by the thermoelectric elements, in terms of the output voltage of the device. However, since the voltages produced by the connectors are so small compared to the voltages produced by the thermoelectric elements, it is substantially irrelevant whether the device uses connector elements and thermoelectric elements of opposite type or the same type.

The thermoelectric material most commonly used as an n-type material in conventional thermoelectric devices is $n\text{-}Bi_2Te_3$, and the material most commonly used for a p-type material in conventional devices is $p\text{-}Bi_2Te_3$. These materials are satisfactory for use at relatively low temperatures, say 200-300°C, but their thermoelectric behaviour falls off drastically with increasing temperature, and they sublime well before a temperature of 800-900°C is reached, which is the region in which it is envisaged that the hot end of the device of the present invention will preferably operate. Accordingly, the present invention preferably employs a thermoelectric metal oxide, for example a $CaMnO_3$-based perovskite-type manganese oxide, or other thermoelectric oxide.

The heat source for the thermoelectric device of the present invention can be radiative, conductive or convective. Particularly where heat is applied by conduction, it is desirable, and may be essential, that the ends of the electrical conductors covering the hot ends of the elements should themselves be covered with an electrically non-conductive layer, in order to prevent the occurrence of short circuits. When heat is applied by conduction it will often be convenient to do this by means of a single hot metal plate supplying heat to all the thermoelectric elements, or a number of such hot plates, with the number being smaller than the number of thermoelectric elements, each supplying heat to more than one thermoelectric element. In such cases short circuiting will occur unless steps are taken to avoid this.

The embodiment of Figure 5 shows the presence of electrically non-conductive layers 50 overlying the conductor portions 38. The layers 50 can, for example, be of a non-electrically conductive oxide. One suitable material is an electrically insulating cement, suitable for high temperature use, which is available under the name Omegabond 600 from Newport Electronics SARL, 78280 Guyancourt, France. This material is capable of withstanding exposure to temperatures up to at least 850°C, without melting or degrading, over the lifetime expected for a typical device. An electrically non-conductive layer should also be provided between the conductor portions 37 and the duct 33. In this case, however, the requirement for resistance to heat is much less than in the case of the layers 50, and a suitable material is an enamel.

Figures 6 and 6a show a further embodiment of the invention, in which the thermoelectric device is made to be sufficiently flexible to enable it to be wound helically around a cylindrical heat source. Thus, the device of Figures 6 and 6a comprises a tubular member 60 defining a passageway 61 through which flows a fluid, normally a gas, at a very high temperature. For example, the tubular member 60 could constitute part of the outlet manifold of an internal combustion engine, through which flow hot exhaust gases. A thermoelectric element 62 is wound helically around the tubular member 60 and comprises a flattened duct 63 through which flows liquid 64 providing the cold end of the device. An array of thermoelectric elements 65 extends between the tubular member 60 and the flattened duct 63.

The elements 65 are electrically interconnected to one another by electrical connection means (not shown), and respective positive and negative terminals (not shown) are provided at opposite ends of the electrical interconnections. Typically, the elements which lie side-by-side with one another in the view of Figure 6 (where there are four such elements) are electrically in parallel with one another, and the successive arrays of such elements, as one passes along the length of the device 62, are in series with one another. The electrical connectors on the ends of the elements 65 adjacent the flattened duct 63 are each covered with a layer of electrically-insulating, but heat-conducting, material. The electrical connectors on the ends of the elements adjacent the tubular member 60 are covered with a layer of electrically insulating, but heat-conducting material capable of withstanding the high temperature to which it is exposed. The elements 65 are secured to the duct 63, but not to the tubular member 60 (or, though less preferably, vice versa).

Although the device of Figures 6 and 6a has been shown with the hot source in the interior, and the cold source running around the exterior, it would be possible to reverse the situation, and have the tubular member 60 provide the cold end of the device, and the flattened duct 63 provide the hot end. However, this is less preferred, since when the tubular member 60 provides the hot end it expands during use, thus forcing itself into closer contact with the adjacent coated ends of the thermoelectric elements. Moreover, another reason for preferring the illustrated configuration is that it limits heat radiation from the hot source to the sides of the thermoelectric elements. Advantageously, fins (not shown), are formed on the inner surface of the tubular member 60, to increase heat convection from the flowing gas.

Referring back to Figure 2 of the accompanying drawings, elimination of the substrate 22 in devices according the present invention removes one major cause of thermal stress, so as to enable a thermoelectric device to operate safely with a high temperature difference across its ends. However, there is still the potential for a certain amount of undesirable stress to arise when, as shown for example in Figure 4, each of the thermoelectric elements is relatively long. In preferred embodiments, therefore, this effect is mitigated by sub-dividing each element into a plurality of legs which extend from a base. This has already been indicated to be the case in relation to Figure 6, where the four elements 65 in each array are, in fact, four sub-divisions of a single element. The principle of sub-division into a plurality of legs is shown further by reference to Figures 7a to 7c. Figure 7a shows a thermoelectric element 70 comprising a base 71 and a plurality of legs 72 which extend from the base in parallel to one another. Adjacent legs are separated from one another by slots 73. As will be explained further below, an element of the type shown in Figure 7a can very conveniently be produced by a moulding process. Figure 7b shows a first electrical connection 74 running underneath the base 71, and a plurality of electrically conductive members 75, one on the end-face of each of the legs 72. Figure 7c shows the conductive members 75 electrically connected to one another by conductive wire portions 76. The base 71 provides the cold end of the device, and the upper ends of the legs 72 provide the hot end. The wire portions 76 are made sufficiently thin that when the upper ends of the legs expand as a result of heating, thereby reducing the width of the slots to an extent which increases progressively as considered along the length of the legs from the base to their hot ends, the wire portions 76 can deform to allow for the reduction in gap size. When heat ceases to be applied to the upper ends of the legs, the wire will be straightened as the width of the gaps 73 once more increases. Provided the wire portions 76 are sufficiently thin and ductile, this process can be repeated almost indefinitely without the wires breaking. Silver is a suitable wire for this purpose, as, for example, is gold, silver-coated copper and silver-coated nickel.

One important aspect of the use of elements which are subdivided into a plurality of legs, is that if one of the legs fails for any reason the device will still function, albeit with a slightly lower current (the voltage is unchanged). In fact, the device will continue to function unless all the legs of at least one element fail.

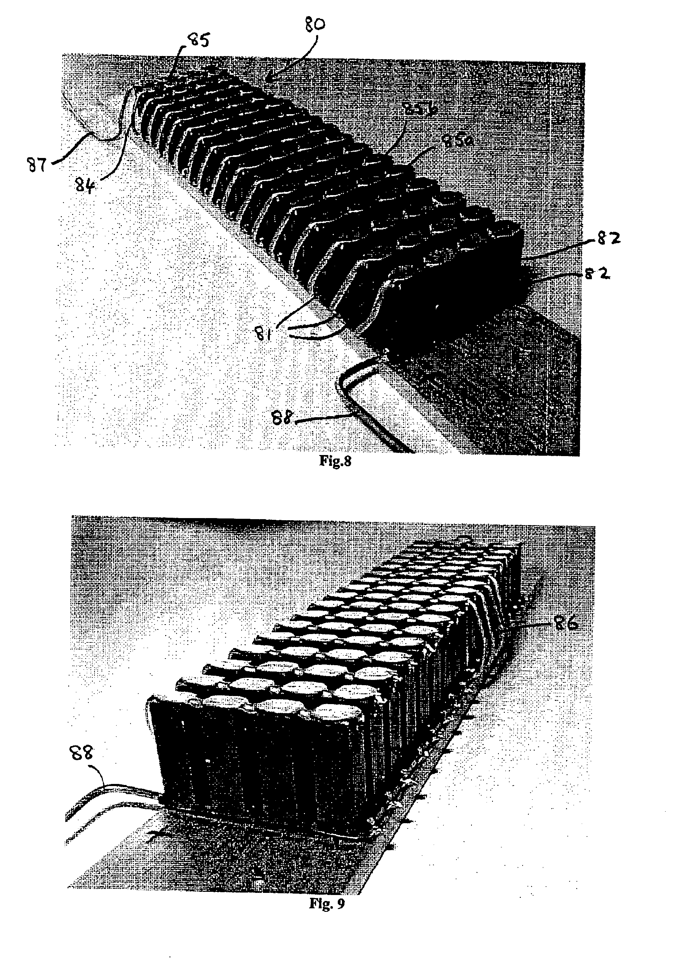

Figures 8 and 9 show the making of a further embodiment of the present invention. The figure shows a thermoelectric device 80 comprising a plurality of thermoelectric elements 81 (by way of example eighteen such elements are shown). Each element 81 is of the general type shown in Figure 7a, in that it comprises a plurality of legs 82 (here four legs), interconnected by a base. A single wire of conductive metal is wrapped around the elements 81 and follows a helical path. As considered from the leftmost of the elements, it will be seen that it comprises a top portion 85 running across the legs of the element concerned, a side portion 86 extending down the side of the far side of the device, and then a portion (not visible) which runs back under the element. This then leads to a side portion 84, which is the first of a series of wire portions surrounding the next of the elements. This sequence continues to the far right hand end of the device. The ends of the spirally wound wire are indicated as 87 and 88.

To convert the intermediate article shown in Figure 8 into a thermoelectric device, the wire portions 86 are removed. Figure 9 shows most of the wire portions 86 removed, but with just a few remaining so that the condition of the device before removal can be understood. The wire portions 85 are pressed into electrical contact with the upper ends of the legs 82. The effect of this, as can be seen in Figures 8 and 9, is that each of the wire portions 85 comprises a plurality of thinner, flattened portions 85a, in contact with the legs, and narrower interconnecting portions 85b between the legs. The wire portions running below the elements, and not visible in Figures 8 and 9, are in electrical contact with the bases of the elements 81. The net effect of the assembly procedure just described is that the base of each element 81 is electrically connected to the upper ends of the legs of the adjacent element, thus forming the same type of series connection as is shown in connection with an earlier embodiment in Figure 3. The wire portions 87 and 88 provide the terminals of the device.

The fact that the electrical connections between adjacent elements of 81 are provided by side portions 84, located laterally outwardly of the elements, i.e. not between them, as in Figures 3 to 5, is particularly advantageous in that it should assist in reducing undesirable transfer of heat to the lower-temperature side of the device. This can be enhanced by incorporating a thermal insulator, for example a heat-resistant fibrous material or a silica aerogel, between adjacent elements, and/or between the elements and the side portions 84.

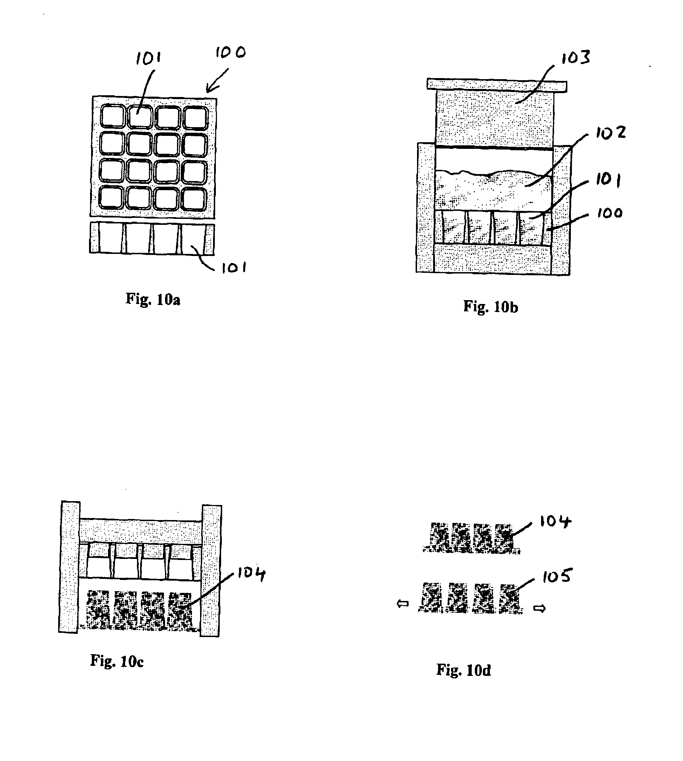

As mentioned above, the thermoelectric elements required for the present invention, and, more particularly, the preferred form of those elements in which each element is subdivided into a plurality of legs, can conveniently be produced by moulding. This is shown diagrammatically in Figures 10 to 10d, which show successive steps in the process. Figure 10a shows, both in plan and vertical section, a mould 100 for producing four thermoelectric elements, each sub-divided into four legs. For this purpose, the mould has sixteen cavities 101. As indicated in Figure 10b, the mould cavities 101 are filled with an excess of material 102 which is pressed into the cavities by means of a presser 103. As shown in Figure 10c, the moulding apparatus is then inverted, and the moulded article 104 is removed from the moulds. The article 104 is sintered and, as shown in Figure 10d, the article 104 is then separated into four thermoelectric elements 105 each of which comprises four legs, though this is not visible in Figure 10d.

In Figures 10a to 10d, the sides of the mould cavities, and therefore the sides of the elements moulded therein, are shown as being at an angle to a line perpendicular to their bases. The angle is exaggerated in Figures 10a to 10d for the sake of illustration. Typically, each side would be at an angle of from 2° to 4° to the perpendicular. However, technology is available from the field of glass micro-reactor fabrication, which makes it possible to eliminate the 2 to 4 degree angle. This increases the cross-section of the ends of the legs remote from their base, which in turn enables the elements to generate more power. Applying that technology to the present case, the thermoelectric powder can be mixed with a wax material and hot-moulded within a silicone rubber mould. For further information regarding that technology, attention is directed to US-A-5853446, which describes a moulding method which is used in a different context but which shows the use of silicone rubber moulds. These are sufficiently flexible that moulded articles can be removed from the moulds without the moulds needing to have inclined sides.

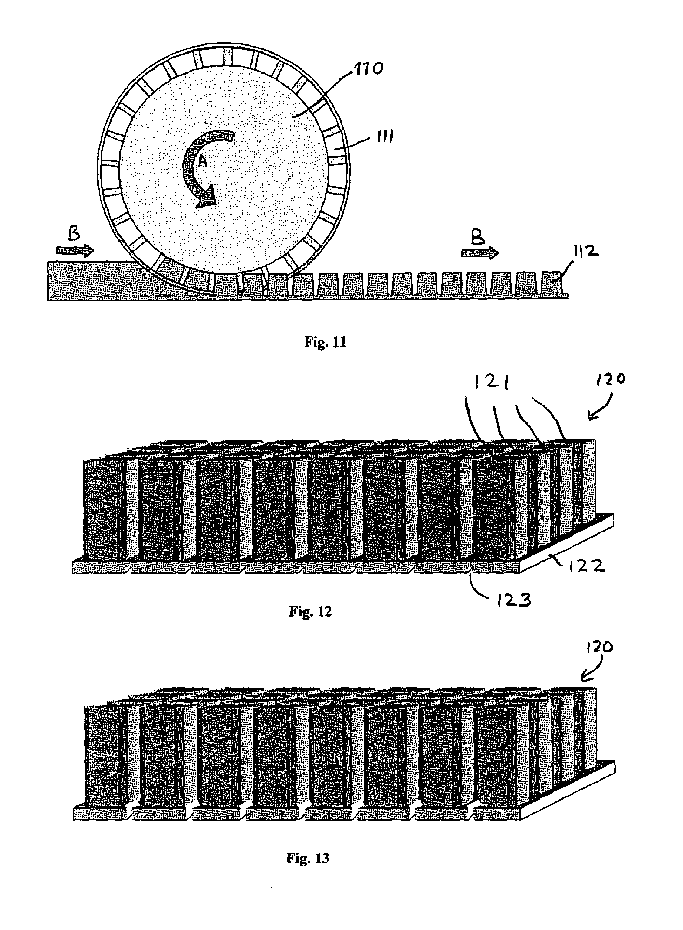

An alternative method of moulding the thermoelectric elements is shown in Figure 11. This employs a cylindrical roller 110, which carries an array of mould cavities 111 on its periphery. The roller 110 rotates in the direction indicated by the arrow A, and material to be moulded passes beneath it in the direction of the arrows B. The roller forms a plurality of thermoelectric elements 112 in the mouldable material. It is to be understood that each of the mould cavities 110 is sub-divided, as considered in a direction extending into the plane of the paper, into a plurality of mould cavities, whereby each of the thermoelectric elements 112 can be formed with a corresponding plurality of legs.

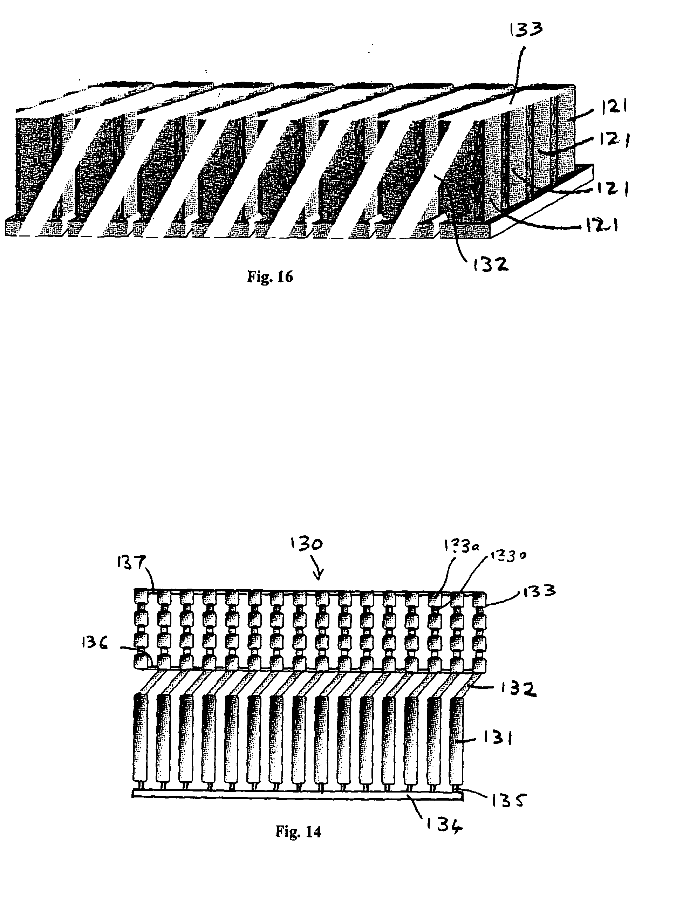

A description will now be given of a method by which thermoelectric devices according to the invention can be assembled rapidly and easily. Initially, a plurality of thermoelectric elements are formed by moulding, as shown in Figure 12. As moulded, the individual thermoelectric elements 120, each of which comprises four legs 121, extending from a base section 122, have their bases joined to one another, but with indentations 123 partly separating each base 122 from its adjacent base or bases. Following sintering, the elements 120 are separated from one another, by fracturing their bases along the indentations 123, to form a plurality of separate elements as shown in Figure 13. However, for ease of subsequent handling, some means (not shown) is desirably provided to hold the elements temporarily together, for example in the form of a tape. For simplicity of illustration, Figures 12 and 13 show eight such elements. In the description below the electrical connections have been shown as applied to an article with eighteen elements, and to follow that description Figures 12 and 13 should be visualised with the requisite additional elements.

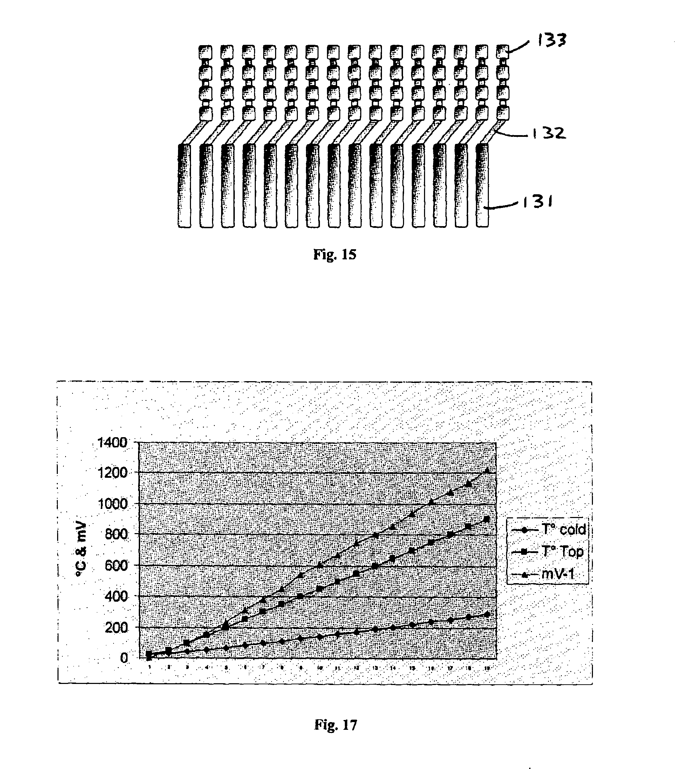

The electrical connections which are to be applied to the thermoelectric elements in order to form the complete thermoelectric device are initially formed as a single electrode frame 130, which is illustrated in Figure 14. (The parts of the frame which are intended to remain after incorporation in the thermoelectric device are shown in Figure 15.) The electrode frame comprises a plurality of bottom electrodes 131, equal in number to the number of thermoelectric elements in the device, each connected by an angled strip 132 to a corresponding top electrode 133. Each electrode 133 comprises a plurality of electrode portions 133a, corresponding in number to the number of legs in each thermoelectric element, electrically interconnected by connector portions 133b. The electrodes 131 and 133, with their angled connections 132, are held together to form an electrode frame by a mounting bar 134 and frangible connections 135, 136 and 137. The electrode frame can be stamped or chemically etched from any suitable sheet material which has a sufficiently high electrical conductivity and sufficient resistance to deterioration under the conditions to which the hot side of the thermoelectric device will be exposed in use. For example, the frame can be formed of silver, silver-plated copper, or nickel-plated copper.

The electrode frame is wrapped around a moulded array of thermoelectric elements, for example of the type shown in Figure 13, and the top electrodes and bottom electrodes are brought into electrical contact with the respective ends of the elements. The frangible connections 135, 136 and 137 are then broken, to leave a device of the type diagrammatically illustrated in Figure 16. This is intended to show only the way in which the thermoelectric elements are electrically connected to one another, and the sub-division of the top electrodes 133 into portions 133a and 133b has been omitted.

In the above discussion, reference has been made at various points to the use of a layer of material

Figure 17 is a graph showing how the voltage produced by a typical thermoelectric device according to the invention varied with the temperatures at hot and cold ends of the device and, hence, on the temperature difference between the ends. The scale at the left hand side of the graph represents both degrees centigrade (from 0 to 1200) and millivolts (from 0 to 1200). The device which was tested to produce these results had twelve thermoelectric elements in series with one another, the elements being made of a $CaMnO_3$-based perovskite-type manganese oxide. The graph shows that even though the temperature of the cold end was allowed to increase as the temperature of the hot end increased, the voltage produced still increased significantly with increasing hot end temperature.

**Claims**

1.   A thermoelectric device comprising a plurality of elements of a thermoelectric material of the same type as one another, each having a first end region for exposure to a first temperature, and a second end region for exposure to a second temperature, with the temperature gradient being in the same direction in each of the elements, whereby each element is adapted to develop a voltage between its end regions in the same direction; a substrate on which the first end regions of the elements are mounted; and electrical connection means for connecting the elements electrically in series, so that the series connection produces a net voltage, the second end regions of the elements being able to move with respect to one another.

2. A device according to claim 1, wherein each said second end region is adapted to be exposed to a higher temperature than its first end region.

3. A device according to claim 1, wherein each said first end region is adapted to be exposed to a higher temperature than its second end region.

4. A device according to any preceding claim, wherein the first end regions terminate in respective first end faces, and the second end regions terminate in respective second end faces, and wherein the electrical connection means comprises, for each adjacent pair of elements, a connector member having a first end portion which extends at least partly across the first end face of one of the pair of elements, a second end portion which extends at least partly across the second end face of the other of the pair of elements, and an intermediate portion extending from the first end portion to the second end portion.

5. A device according to claim 4, wherein the end faces which are to be exposed to the higher temperature are coated with a material which is heat-resistant, thermally conductive, and electrically insulating.

6. A device according to claim 4 or 5, wherein the intermediate portions are in the form of wires.

7. A device according to claim 4 or 5, wherein the intermediate portions are in the form of sheets.

8. A device according to any preceding claim, wherein each element comprises a base which provides one of the end regions, and a plurality of legs extending therefrom and providing, at their ends remote from the base, the other of the end regions.

9. A device according to any preceding claim, wherein the device is sufficiently flexible to be wrapped around a surface at the said first or second temperatures, so as to be in thermal contact therewith.

10. A device according to any preceding claim, wherein the thermoelectric elements and the means for connecting the elements in series are formed of different types of material.

11. A device according to any one of claims 1 to 9, wherein the thermoelectric elements and the means connecting the elements in series are formed of materials of opposite type.

12. A device according to any preceding claim, wherein the thermoelectric elements are disposed in an array with adjacent elements having sides which face one another across a gap, and wherein the connection means are located outside the said gaps.

13. A method of making a thermoelectric device comprising a plurality of elements of a thermoelectric material of the same type as one another, each having a first end region for exposure to a first temperature, and a second end region for exposure to a second temperature, with the temperature gradient being in the same direction in each of the elements, whereby each element is adapted to develop a voltage between its end regions in the same direction; a substrate on which the first end regions of the elements are mounted; and electrical connection means for connecting the elements electrically in series, so that the series connection produces a net voltage, the second end regions of the elements being able to move with respect to one another, the method comprising:

(a) forming the said plurality of elements by moulding;
(b) forming an electrode frame containing the electrical connection means;
(c) wrapping the electrode frame around the plurality of elements so as to establish the necessary electrical connections; and, optionally,
(d) breaking away any parts of the electrode frame not required to establish the necessary electrical connections.

14. A method according to claim 13, wherein the moulding step comprises forcing material to form the thermoelectric elements into a planar mould, and expelling the moulded material therefrom.

15. A method according to claim 13, wherein the moulding step comprises bringing into forcible contact with one another material to form the thermoelectric elements and a rotating cylindrical mould having mould cavities formed on a cylindrical peripheral surface thereof.

16. A thermoelectric device comprising a plurality of elements of a thermoelectric material, each having a first end region for exposure to a first temperature, and a second end region for exposure to a second temperature, with the temperature gradient being in the same direction in each of the elements, a substrate on which the first ends regions of the elements are mounted; and electrical connection means for connecting the elements electrically in series, so that the series connection produces a net voltage, the second end regions of the elements being able to move with respect to one another.

17. A method of making a thermoelectric device comprising a plurality of elements of a thermoelectric material of the same type as one another, each having a first end region for exposure to a first temperature, and a second end region for exposure to a second temperature, with the temperature gradient being in the same direction in each of the elements, whereby each element is adapted to develop a voltage between its end regions in the same direction; a substrate on which the first end regions of the elements are mounted; and electrical connection means for connecting the elements electrically in series, so that the series connection produces a net voltage, the second end regions of the elements being able to move with respect to one another, the method comprising:

(a) forming the said plurality of elements so that they are disposed parallel to one another;
(b) winding an electrically conductive member around the plurality of elements in the form of a generally helical coil with a plurality of turns, with each turn being successively in electrical contact with one end of a respective element and the other end of the same element, and thence leading to an adjacent element; and
(c) severing each turn where it leads from one end of each element to the other end of the same element.

**Fig. 1**

$$\Delta V_{oc} = \alpha(T_{sh} - T_{sc})$$

**Fig. 2**

**Fig. 3**

Fig. 4

Fig. 5

Fig. 6

Fig. 6a

Fig. 7a

Fig. 7b

Fig. 7c

Fig.8

Fig. 9

Fig. 10a

Fig. 10b

Fig. 10c

Fig. 10d

**Fig. 11**

**Fig. 12**

**Fig. 13**

**Fig. 16**

**Fig. 14**

133
132
131

Fig. 15

Fig. 17

**European Patent Office**

## EUROPEAN SEARCH REPORT

Application Number

EP 05 29 2627

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/209014 A1 (CHANG CHIH-WEI ET AL) 13 November 2003 (2003-11-13) * figure 4 * | 1-4,6, 12,16 | INV. H01L35/32 H01L35/34 |
| X | PATENT ABSTRACTS OF JAPAN vol. 2002, no. 08, 5 August 2002 (2002-08-05) -& JP 2002 111080 A (MATSUSHITA ELECTRIC WORKS LTD), 12 April 2002 (2002-04-12) * abstract * | 1-4,7, 10,12,16 | |
| X | WO 2004/049463 A (VENKATASUBRAMANIAN, RAMA; COONLEY, KIP; SIIVOLA, EDWARD; PUCHAN, MICHA) 10 June 2004 (2004-06-10) * figures 2-5 * | 1-4,7, 10,12,16 | |
| A,D | US 2005/016183 A1 (TATEYAMA KAZUKI ET AL) 27 January 2005 (2005-01-27) * the whole document * | 1-12,16 | |
| A | PATENT ABSTRACTS OF JAPAN vol. 1997, no. 12, 25 December 1997 (1997-12-25) -& JP 09 224387 A (WAKABAYASHI TADATOSHI), 26 August 1997 (1997-08-26) * abstract; figures 5,6 * | 9 | TECHNICAL FIELDS SEARCHED (IPC) H01L |

~~The present search report has been drawn up for all claims~~

| Place of search | Date of completion of the search | Examiner |
|---|---|---|
| The Hague | 29 June 2006 | Kirkwood, J |

European Patent
Office

Application Number

EP 05 29 2627

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-12,16

20

European Patent
Office

**LACK OF UNITY OF INVENTION
SHEET B**

Application Number

EP 05 29 2627

The Search Division considers that the present European patent application does not comply with the requirements of unity of invention and relates to several inventions or groups of inventions, namely:

1. claims: 1-12,16

   Thermoelectric device comprising a plurality of elements of thermoelectric material in series

   ---

2. claims: 13-15, 17

   A method of making a thermoelectric device comprising a plurality of elements of thermoelectric material of the same type, comprising moulding and wrapping or winding an electrode frame around the elements then breaking away or severing unnecessary parts.

   ---

## ANNEX TO THE EUROPEAN SEARCH REPORT
## ON EUROPEAN PATENT APPLICATION NO.

EP 05 29 2627

This annex lists the patent family members relating to the patent documents cited in the above-mentioned European search report.
The members are as contained in the European Patent Office EDP file on
The European Patent Office is in no way liable for these particulars which are merely given for the purpose of information.

29-06-2006

| Patent document cited in search report | | Publication date | Patent family member(s) | | Publication date |
|---|---|---|---|---|---|
| US 2003209014 | A1 | 13-11-2003 | NONE | | |
| JP 2002111080 | A | 12-04-2002 | NONE | | |
| WO 2004049463 | A | 10-06-2004 | AU | 2003293034 A1 | 18-06-2004 |
| | | | EP | 1579512 A1 | 28-09-2005 |
| | | | JP | 2006507690 T | 02-03-2006 |
| US 2005016183 | A1 | 27-01-2005 | CN | 1604353 A | 06-04-2005 |
| | | | EP | 1505662 A2 | 09-02-2005 |
| | | | JP | 2005064457 A | 10-03-2005 |
| | | | US | 2006123799 A1 | 15-06-2006 |
| JP 09224387 | A | 26-08-1997 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050016183 A, Tateyama
- US 20040107988 A
- US 5853446 A